# FASCICULE DE BREVET EUROPEEN

(11) **EP 1 948 846 B1**
(45) Date de publication et mention de la délivrance du brevet: **06.05.2009**
(21) Numéro de dépôt: 06831026.7
(22) Date de dépôt: 26.10.2006
(51) Int. Cl.: C23C 16/52, C23C 16/511, H01J 37/32

(54) **Méthode de surveillance d'un plasma et application de cette méthode au dépot d'un film sur corps creux en PET**
Verfahren zur Überwachung eines Plasmas und Verwendung dieses Verfahrens zur Ablagerung eines Films auf einem PET-Hohlkörper
Method of monitoring a plasma and use of this method for depositing a film onto a PET hollow body

(30) Priorité: 27.10.2005 FR 0510998
(43) Date de publication de la demande: 30.07.2008
(73) Titulaire: Sidel Participations, 76930 Octeville Sur Mer (FR)
(72) Inventeur: RIUS, Jean-Michel, F-76930 Octeville sur Mer (FR); FEUILLOLEY, Guy, F-76930 Octeville sur Mer (FR)
(74) Mandataire: Cabinet Plasseraud
(86) Numéro de dépôt international: PCT/FR2006/002412
(87) Numéro de publication internationale: WO 2007/048937

(56) Documents cités:
- EP-A- 0 299 752
- EP-A- 1 500 600
- EP-A1- 0 604 344
- US-A- 5 831 728
- US-A- 6 117 243
- US-A1- 2002 094 681

## Description

L'invention se rapporte au domaine technique des produits polymères revêtus par dépôt plasma d'une couche mince, sur au moins une de leurs faces.

L'invention s'applique notamment, mais non exclusivement, aux dépôts plasma dans des récipients en matériau polymère, tels que des bouteilles en PET (polyéthylène téréphtalate).

Les matériaux polymères conventionnels employés pour la fabrication des bouteilles ou récipients, tels que le PET, présentent tous une relative perméabilité à l'oxygène et au dioxyde de carbone. Qui plus est, certaines molécules, participant aux arômes, peuvent être adsorbées sur la paroi des récipients, et diffuser à terme au travers de ces parois.

Assez récemment, il a été proposé d'utiliser les plasmas pour le dépôt de couches barrières sur des récipients polymères, tels que des bouteilles, devant contenir des produits sensibles à l'oxydation (bières, jus de fruit, boissons carbonatées) afin d'augmenter l'imperméabilité de ces récipients à certains gaz tels que l'oxygène et le dioxyde de carbone, et d'en repousser en conséquence la date limite d'utilisation optimale (DLUO ou « shelf life »).

Ces couches barrières déposées par plasma dans les récipients polymères sont, à titre d'exemple, de type organique (carbone) ou inorganique (silice).

Quelle que soit leur nature chimique, il est de grande importance industrielle de pouvoir contrôler la qualité de ces couches barrières.

Il a été évoqué l'emploi de la spectroscopie d'émission optique pour étudier les réactions au sein du plasma et pour contrôler les dépôts obtenus par CVD (US 6 117 243, colonne 1 lignes 28 à 37). Le document US 5 521 351 illustre (figure 7) et évoque (colonne 7 lignes 38 à 45) la mise en place d'une fibre optique à l'intérieur d'une bouteille, lors du dépôt plasma, cette fibre optique étant reliée à un spectromètre d'émission optique. Ce document US 5 521 351 est toutefois muet quant aux paramètres mesurés. De plus, la mise en place de la fibre dans le récipient contenant le plasma entraîne inévitablement un dépôt sur la fibre optique elle-même, et son encrassement à terme.

La demanderesse s'est attachée à développer une technique de surveillance de la composition des plasmas, permettant de prédéterminer la qualité des dépôts obtenus par ces plasmas.

La demanderesse s'est attachée à ce que cette technique de surveillance permette non pas seulement un échantillonnage, mais un contrôle en continu et ce pour des machines à grande cadence.

Le document EP 0 299 752 divulgue un procédé de dépôt d'un film fin par plasma sur une surface d'un substrat où l'émission optique du plasma est surveillée et contrôlée. Selon cette invention, il est détecté l'intensité de deux raies d'émission à des bandes de longueur d'onde différentes correspondant à deux espèces présentes dans le plasma, les intensités étant mise en rapport et le rapport étant ensuite comparé à une valeur de référence. Toutefois, le choix des espèces se fait parmi des espèces qui sont contenues dans les précurseurs et qui sont donc nécessairement présentes dans le plasma surveillé. En fonction de la valeur de ce rapport, qui permet de déterminer la prépondérance de l'une ou de l'autre des espèces et donc la qualité du film déposé, il est alors modifié le débit des précurseurs injectés dans le volume où est généré le plasma.

Toutefois, afin de permettre la formation d'une couche interne dans le volume interne d'un récipient, il est nécessaire de placer le volume interne du récipient à une pression plus ou moins basse lors de la génération du plasma. Cette mise sous pression interne nécessitant la formation d'un contact étanche entre le récipient et la machine de formation du plasma peut résulter en la formation de fuites entraînant l'arrivée d'air à l'intérieur du volume interne du récipient, fuites susceptibles de nuire à la bonne qualité et homogénéité du dépôt de la couche interne, du fait de l'introduction d'espèces non souhaitées.

Le procédé dans le document EP 0 299 752 ne permet pas de contrôler la présence d'éléments étrangers dans le plasma et de détecter, dans le cas où le plasma est formé à l'intérieur d'un récipient, la formation d'une fuite et d'une mauvaise étanchéité entre le volume interne du récipient et l'air ambiant susceptible de résulter en la formation d'une couche interne non homogène ou de présenter des fissures, du fait qu'il est uniquement surveillé des espèces chimiques volontairement injectées dans le plasma.

La présente invention a plus particulièrement pour but de détecter la présence d'une fuite dans le volume interne du récipient lors de la génération du plasma.

A ces fins, l'invention se rapporte, selon un premier aspect, à une méthode de surveillance de la composition d'un plasma, ce plasma étant généré à partir de précurseurs déterminés pour le dépôt d'un film sur un matériau polymère, cette méthode comprenant la réception d'intensités lumineuses émises par le plasma, cette méthode étant caractérisée en ce qu'elle comprend :
- une étape de choix d'une première gamme de longueurs d'ondes, dite de référence, qui est choisie dans un domaine du spectre d'émission du plasma dans lequel il ne peut exister aucun signal significatif d'une espèce chimique dite parasite, c'est-à-dire qui ne fait pas partie desdits précurseurs déterminés et qui n'est donc normalement pas présente dans le plasma et dont la présence dans le plasma influe sur la nature du film déposé ;
- une étape de choix d'une seconde gamme de longueurs d'ondes qui est choisie dans un domaine du spectre d'émission du plasma dans lequel il est susceptible d'exister un signal significatif d'une espèce chimique parasite ;
- une étape d'acquisition simultanée des intensités lumineuses émises par le plasma dans chacune des deux gammes de longueurs d'ondes choisies ;
- une étape de calcul, à partir desdites intensités lumineuses d'au moins un coefficient de surveillance.

Dans une première mise en oeuvre, les deux gammes de longueurs d'ondes sont de très faible largeur spectrale et correspondent sensiblement à deux longueurs d'ondes λ1 et λ2.

Au moins un coefficient de surveillance est fonction de la différence entre les intensités d'émission pour lesdites première et deuxième longueurs d'ondes.

Plus particulièrement, au moins un coefficient de surveillance est fonction de la différence entre les intensités d'émission pour lesdites première et deuxième longueurs d'ondes, différence rapportée à la valeur de l'intensité d'émission pour la première ou la deuxième longueur d'ondes.

Dans une deuxième mise en oeuvre, les deux gammes de longueurs d'ondes ont chacune une largeur spectrale et correspondent à deux bandes passantes.

Au moins un coefficient de surveillance est fonction de la différence entre les intensités d'émission pour lesdites première et deuxième bandes passantes.

Plus particulièrement, au moins un coefficient de surveillance est fonction de la différence entre les intensités d'émission pour lesdites première et deuxième bandes passantes, différence rapportée à la valeur d'émission pour la première ou la deuxième bande passante.

L'espèce chimique parasite choisie susceptible de provoquer un signal significatif dans la seconde gamme de longueurs d'ondes est par exemple une espèce non souhaitée dans le film à déposer par plasma sur le matériau polymère.

Dans certaines réalisations, le précurseur gazeux est choisi parmi les alcanes, les alcènes, les alcynes, et les aromatiques, ladite espèce chimique parasite susceptible de provoquer un signal significatif dans la seconde gamme de longueurs d'ondes étant un des constituants de l'air.

Dans une réalisation particulière, le précurseur est à base d'acétylène, l'espèce chimique parasite étant l'azote. La méthode de surveillance permettra ainsi, par exemple, de déceler une fuite d'air dans l'installation de dépôt plasma.

Avantageusement, les gammes de longueurs d'ondes sont choisies dans la partie du spectre d'émission comprise entre sensiblement 800 et sensiblement 1000 nanomètres.

L'invention se rapporte, selon un deuxième aspect, à l'application de la méthode de surveillance de la composition d'un plasma telle que présentée ci-dessus, le plasma étant un plasma micro-ondes pour dépôt d'un film sur un corps creux en PET.

D'autres aspects, objets et avantages de l'invention apparaîtront au cours de la description suivante de modes de réalisation, description qui va être effectuée à la lumière des dessins annexés dans lesquels :
- la figure 1 est une vue en coupe d'une partie de machine vendue par la demanderesse sous le nom Actis^{®}, cette figure 1 montrant en outre un dispositif mettant en oeuvre le procédé selon l'invention connecté à la machine Actis^{®} ;
- la figure 2 représente plusieurs spectres d'émission optique, obtenus pour des bouteilles traitées selon le procédé Actis^{®} de la demanderesse, deux longueurs d'ondes particulières étant choisies pour le calcul d'un coefficient de surveillance, selon un mode de réalisation de la présente invention ;
- la figure 3 représente plusieurs spectres d'émission optique, obtenus pour des bouteilles traitées selon le procédé Actis^{®} de la demanderesse, deux gammes de longueurs d'ondes étant choisies pour le calcul d'un coefficient de surveillance, selon un deuxième mode de réalisation de l'invention.

La description détaillée qui suit va être effectuée en référence au dépôt d'une couche mince de carbone amorphe par plasma, via une technique de la demanderesse, technique connue sous le nom d'Actis^{®}.

Il est entendu toutefois qu'il ne s'agit là que d'un exemple de mise en oeuvre de la méthode selon l'invention.

La description détaillée qui suit va être effectuée en référence au dépôt d'un film sur des bouteilles, ou des ébauches de bouteilles.

Il est entendu toutefois que la méthode pourra être mise en oeuvre au cours d'un dépôt plasma sur un matériau polymère pour l'élaboration d'autres contenants que des bouteilles : corps creux moulés, injectés, pultrudés, soufflés, thermoformés.

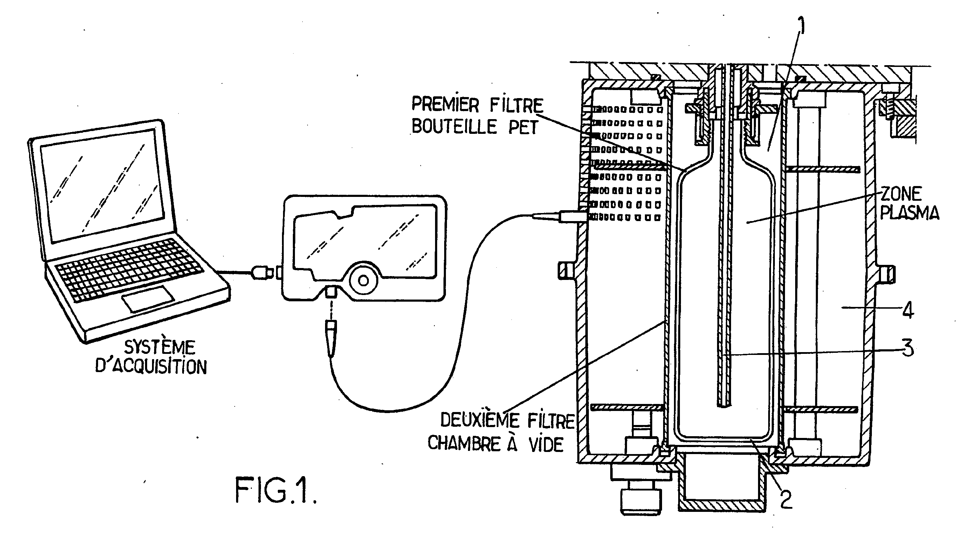

On se réfère tout d'abord à la figure 1.

Ainsi qu'il a été décrit dans le document WO 99/49991 de la demanderesse, une machine (de type Actis^{®})) comprend au moins une enceinte 1 définie par des parois en un matériau transparent pour les micro-ondes, par exemple en quartz.

Cette enceinte 1 est fermée par un mécanisme amovible permettant la mise en place de l'objet à traiter, ici une bouteille ou une ébauche de bouteille 2, et son enlèvement après traitement.

Cette enceinte 1 est raccordée à des moyens de pompage, non représentés.

Pour l'injection d'au moins un précurseur gazeux dans la bouteille 2, un injecteur 3 est prévu, raccordé à un réservoir, un mélangeur, ou un bulleur (non représentés).

L'enceinte 1 est placée dans une cavité 4 à parois conductrices, par exemple métalliques, connectée, par un guide d'ondes, à un générateur de micro-ondes.

Dans le cas où l'on cherche à déposer du carbone sur la surface interne de la bouteille ou de l'ébauche de bouteille, le précurseur gazeux peut être choisi parmi les alcanes (par exemple le méthane), les alcènes, les alcynes (par exemple l'acétylène) et les aromatiques.

La pression au sein de la chambre de réaction, constituée par l'ébauche de bouteille ou la bouteille 2, doit être faible, de préférence inférieure à 10 mbar, et notamment comprise entre 0.01 et 0.5 mbar.

Pour éviter une déformation de la bouteille ou de l'ébauche de bouteille, le différentiel de pression entre l'intérieur et l'extérieur de la bouteille (ou de l'ébauche) est réduit, une dépression étant effectuée à l'intérieur de l'enceinte.

Une étanchéité est par ailleurs réalisée au goulot de la bouteille ou de l'ébauche, une mauvaise étanchéité pouvant résulter en la présence de fuites entre le volume interne de la bouteille et l'air extérieur.

Par ces dispositions, un plasma est réalisé dans l'ébauche (ou la bouteille), qui constitue elle-même la chambre de réaction, réduisant ainsi le risque de formation d'un plasma contre la surface extérieure de la bouteille (ou l'ébauche), les parois transparentes de l'enceinte n'étant ainsi pas encrassées.

A titre d'exemple, pour une excitation UHF de 2.45 GHz et une puissance micro-ondes de 180 W, un dépôt de carbone à pu être obtenu avec une vitesse de croissance de l'ordre de 250 angströms par seconde avec un débit d'acétylène de 80 sccm sous pression de 0.25 mbar, une pression résiduelle de 0.2 mbar étant maintenue à l'intérieur de la bouteille (ou de l'ébauche), une pression résiduelle de 50 mbar à l'intérieur de l'enceinte et à l'extérieur de la bouteille (ou de l'ébauche) étant suffisante pour empêcher la déformation de ladite bouteille (ou ladite ébauche) lors du dépôt de carbone.

Pour une bouteille de 390 ml (13 Oz, 26.5g PET), le précurseur est par exemple injecté après un temps T1 de l'ordre de 1.5 secondes, temps T1 dit de balayage au cours duquel la bouteille - ou l'ébauche de bouteille - est balayée par un flux d'acétylène, la pression étant graduellement réduite jusqu'à une valeur de l'ordre de 0.25 mbar. Puis, tout au long d'un temps T2 de dépôt, de l'ordre de 1.2 secondes, un champ électromagnétique est appliqué dans la bouteille - ou l'ébauche -, le précurseur étant de l'acétylène injecté à un débit de l'ordre de 100 sccm, la puissance micro-ondes étant d'environ 200 W pour une fréquence de 2.45 Ghz, l'épaisseur de carbone obtenue étant de l'ordre de 40 nanomètres.

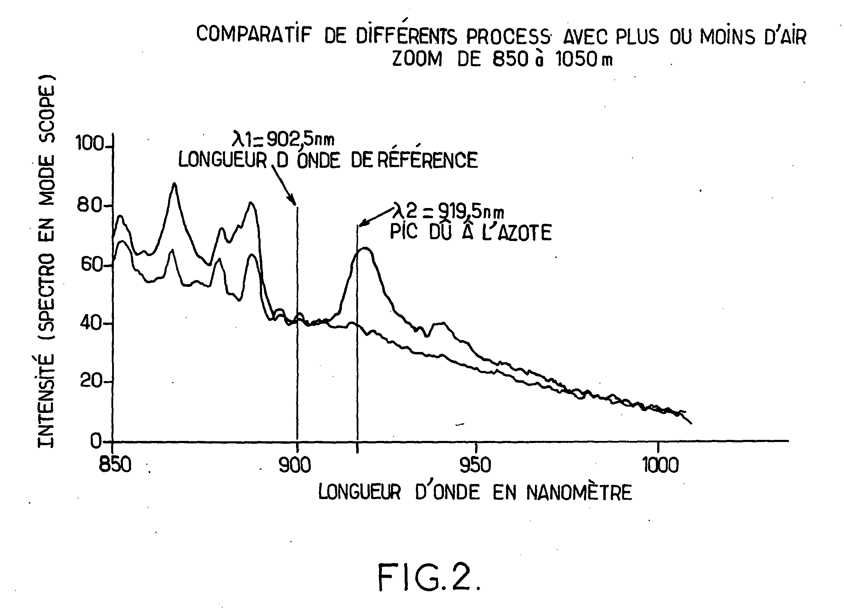

On se réfère maintenant à la figure 2.

La présente invention porte, de manière générale, sur une méthode de surveillance de la composition d'un plasma, ce plasma étant généré à partir de précurseurs déterminés pour le dépôt d'un film sur un matériau polymère, cette méthode comprenant la réception d'intensités lumineuses émises par le plasma.

Dans une première mise en oeuvre de la méthode, deux longueurs d'ondes λ1 et λ2 sont fixées, la première longueur d'onde λ1 étant de référence, et choisie dans une gamme de longueurs d'ondes dans laquelle il ne peut exister aucun pic significatif d'une espèce chimique parasite à l'égard du film à déposer. Par espèce parasite, on entend désigner une espèce chimique qui ne fait pas partie des précurseurs, qui n'est normalement pas présente dans le plasma et dont la présence dans le plasma influe sur la nature du film déposé. L'espèce chimique parasite est, selon une forme de réalisation de l'invention, une espèce non souhaitée dans le film à déposer par plasma sur le matériau polymère.

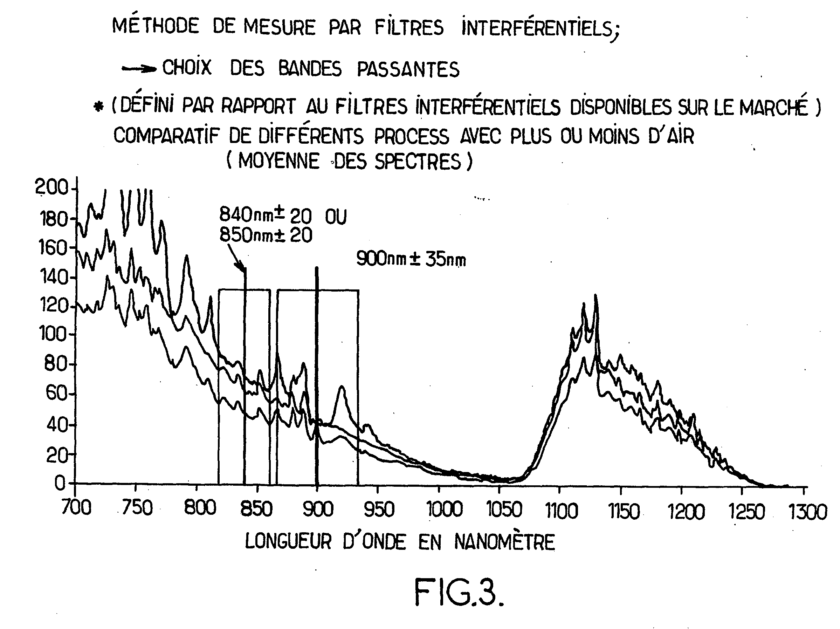

Dans l'exemple illustré en figure 2, cette longueur d'onde λ1 est de 902.5 nanomètres. De manière générale, et tel que cela sera explicité en rapport avec la figure 3, la méthode selon l'invention prévoit une étape de choix d'une première gamme de longueurs d'ondes, dite de référence, qui est choisie dans un domaine du spectre d'émission du plasma dans lequel il ne peut exister aucun signal significatif d'une espèce chimique parasite. Selon le mode de réalisation illustré à la figure 2, la gamme de longueurs d'ondes de référence est de très faible largeur spectrale et correspond sensiblement à la longueur d'onde λ1.

La première gamme de longueur d'ondes est donc choisie dans une partie du spectre d'émission du plasma dont les caractéristiques restent sensiblement constantes et homogènes aussi bien en présence d'une espèce de référence que d'une espèce parasite, c'est-à-dire une partie du spectre qui n'est pas sensiblement modifiée en présence d'espèces susceptibles d'influer sur la nature de la couche de matériau déposé.

La seconde longueur d'ondes λ2, est quant à elle, tout au contraire de λ1, spécifiquement dédiée à une espèce chimique qui n'intervient normalement pas dans le processus de dépôt du film, sauf en cas de problème. Cette espèce chimique peut être par exemple un constituant dont la concentration dans le film déposé influe sur les propriétés de ce film. En particulier, cette espèce chimique pourra avoir un effet néfaste sur les propriétés barrières du film, ou bien encore ses propriétés mécaniques ou optiques. Autrement dit, de manière générale, et tel que cela sera explicité en rapport avec la figure 3, la méthode selon l'invention prévoit une étape de choix d'une seconde gamme de longueurs d'ondes qui est choisie dans un domaine du spectre d'émission du plasma dans lequel il est susceptible d'exister un signal significatif de ladite espèce chimique parasite, lequel signal est plus ou moins marqué selon la concentration de l'espèce parasite considérée. Selon le mode de réalisation illustré à la figure 2, la gamme de longueurs d'ondes de référence est de très faible largeur spectrale et correspond sensiblement à la longueur d'onde λ2.

Dans l'exemple illustré en figure 2, cette longueur d'onde λ2 est de 919.5 nanomètres et est issue de l'azote. La méthode selon l'invention permet ainsi, notamment, de déceler la présence d'une fuite d'air dans une installation de dépôt plasma, l'espèce chimique parasite choisie étant alors avantageusement choisie parmi les constituants de l'air (azote, oxygène, etc ....)

La valeur de l'intensité des deux raies obtenues pour ces longueurs d'ondes λ1 et λ2 est acquise simultanément et un coefficient de surveillance N est calculé à partir de ces deux intensités relevées simultanément. Le fait que l'acquisition soit effectuée de façon simultanée permet de s'affranchir non seulement des variations d'intensité liées à la pulsation du plasma mais encore, entre autres, des variations au fur et à mesure que le processus de déposition se déroule.

Dans l'exemple de la figure 2, ce coefficient N vaut (Iλ2-Iλ1)/Iλ2, différence entre les intensités des raies obtenues pour λ2 et λ1, rapportée à l'intensité obtenue pour λ2.

Ainsi, la méthode selon l'invention comprend de plus une étape d'acquisition simultanée des intensités lumineuses émises par la plasma dans chacune des deux gammes de longueurs d'ondes choisies et une étape de calcul, à partir desdites intensités lumineuses d'au moins un coefficient de surveillance.

Ce rapport est associé, par exemple à l'aide de tables de corrélation expérimentale, à diverses propriétés du film déposé : par exemple perméabilité à l'oxygène de la bouteille revêtue, perméabilité au dioxyde de carbone de la bouteille revêtue, épaisseur de film, couleur du film, composition du film.

Préférentiellement, ledit au moins un coefficient de surveillance est fonction de la différence entre les intensités d'émission pour les première et deuxième longueurs d'ondes λ1 et λ2.

De manière avantageuse, le coefficient de surveillance est fonction de la différence entre les intensités d'émission pour lesdites première et deuxième longueurs d'ondes λ1 et λ2, différence rapportée à la valeur de l'intensité d'émission pour la première ou deuxième longueur d'onde.

Il est ainsi possible, en fonction des caractéristiques souhaitées pour la bouteille, de déterminer une valeur ou une gamme de valeurs de coefficient de surveillance et de déceler une dérive ou une anomalie dans le procédé de dépôt plasma, la correction rapide de cette anomalie limitant le volume de bouteilles non conformes aux souhaits.

On se réfère maintenant à la figure 3. Dans cette deuxième mise en oeuvre de la méthode, deux fenêtres ou gammes de longueurs d'ondes λ1 et λ2 ayant chacune une largeur spectrale, et correspondant à deux bandes passantes, sont fixées, la première fenêtre de longueur d'onde λ1 étant de référence, et choisie dans une gamme de longueur d'onde dans laquelle il n'existe aucun pic significatif d'une espèce chimique intéressant le film à déposer, à savoir une gamme de longueurs d'ondes, dite de référence, qui est choisie dans un domaine du spectre d'émission du plasma dans lequel il ne peut exister aucun signal significatif d'une espèce chimique parasite.

Dans l'exemple illustré en figure 3, cette fenêtre de longueur d'onde λ1 est centrée sur 840 ou 850 nanomètres, avec une largeur de 40 nanomètres.

La seconde fenêtre de longueur d'onde λ2, est, quant à elle, tout au contraire de λ1, spécifiquement dédiée à une espèce chimique intervenant dans le processus de dépôt du film, à savoir dans une gamme de longueurs d'ondes qui est choisie dans un domaine du spectre d'émission du plasma dans lequel il est susceptible d'exister un signal significatif de ladite espèce chimique parasite.

Dans l'exemple illustré en figure 3, cette fenêtre de longueurs d'onde λ2 est centrée sur 900 nanomètres, avec une largeur de 70 nanomètres, et permet d'inclure les pics de l'azote à 870, 885, 920 nanomètres.

Les valeurs des intensités U1, U2 des deux bandes passantes obtenues sont acquises simultanément et un coefficient de surveillance N est calculé à partir de ces deux intensités relevées simultanément. Comme précédemment, le fait que l'acquisition soit effectuée de façon simultanée permet de s'affranchir non seulement des variations d'intensité liées à la pulsation du plasma mais encore, entre autres, des variations au fur et à mesure que le processus de déposition se déroule.

Dans l'exemple de la figure 3, ce coefficient N vaut (U2-U1)/U2, différence entre les intensités des bandes passantes, rapportée à l'intensité de la bande passante centrée sur la deuxième longueur d'onde λ2.

Préférentiellement, le coefficient de surveillance est fonction de la différence entre les intensités d'émission pour lesdites première et deuxième bandes passantes.

Plus précisément, le coefficient de surveillance est fonction de la différence entre les intensités d'émission pour lesdites première et deuxième bandes passantes, différence rapportée à la valeur d'émission pour la première ou la deuxième bande passante.

Ce rapport est associé, par exemple à l'aide de tables de corrélation expérimentale, à diverses propriétés du film déposé : par exemple perméabilité à l'oxygène de la bouteille revêtue, perméabilité au dioxyde de carbone de la bouteille revêtue, épaisseur de film, couleur du film, composition du film.

Il est ainsi possible, en fonction des caractéristiques souhaitées pour la bouteille, de déterminer une valeur ou une gamme de valeurs de coefficient de surveillance et de déceler une dérive ou une anomalie dans le procédé de dépôt plasma, la correction rapide de cette anomalie limitant le volume de bouteilles non conformes aux souhaits.

La demanderesse a constaté qu'en travaillant sur la gamme spectrale de sensiblement 800 à sensiblement 1000 nanomètres, il était possible de s'affranchir de l'impact de la couleur d'une couche de carbone amorphe, telle que par exemple déposée par le procédé Actis^{®}, ainsi que de la couleur de la bouteille, les détecteurs pouvant ainsi être placés contre la cavité 4 en parois conductrices, le plasma étant vu au travers de la paroi de la bouteille et au travers des parois de l'enceinte 1.

Dans une réalisation avantageuse, les spectromètres sont fixés sur chaque cavité de la machine de production, un multiplexage optique ou électronique permettant le contrôle de plusieurs plasmas.

Dans une réalisation, une fibre optique est placée dans l'injecteur de gaz précurseur et protégée de ce fait d'un encrassement, cette réalisation permettant de s'affranchir du filtre dû à la paroi de la bouteille et aux parois de l'enceinte 1, les longueurs d'ondes λ1 et λ2 des raies ou des bandes passantes pouvant ainsi être choisies dans le proche UV.

Selon une application préférentielle de la méthode de surveillance de la composition d'un plasma, le plasma est un plasma micro-ondes pour le dépôt d'un film sur un corps creux en PET.

La méthode selon l'invention offre de nombreux avantages.

Elle permet de déceler au plus tôt une anomalie de fonctionnement de la machine de production, par exemple une fuite d'air.

Si cette machine peut fonctionner à grande cadence, comme c'est le cas pour les machines de la demanderesse, la méthode selon l'invention permet de déceler tout mauvais réglage des paramètres de fabrication, et de limiter les rebuts.

Ainsi, en fonction de la valeur du rapport calculé selon l'invention, il est décidé si la couche interne du récipient s'est formée correctement et si le récipient formé doit être mis au rebut et écarté de la ligne de production.

La méthode selon la présente invention a principalement pour but de surveiller la qualité du plasma formé et ne prévoit pas de modifier en conséquence au cas par cas les paramètres de réglage du plasma. Néanmoins, quand il est constaté qu'un grand nombre de récipients sont consécutivement mis au rebut, alors il est envisageable de prévoir d'arrêter le fonctionnement de la machine de formation du plasma et de modifier en conséquence les paramètres de formation du plasma.

Selon l'invention, il est également décidé dans quel écart, par rapport à la valeur de référence, la nature de la couche interne peut être considérée comme étant acceptable en fonction de la nature du récipient et de ses caractéristiques.

Dans le cas où une fuite est détectée, selon la présente invention, le récipient est soit rejeté de la ligne de production, soit il est considéré que l'influence de la fuite sur la formation par plasma de la couche interne n'est que faiblement modifiée en fonction de la valeur du rapport et de l'écart acceptable.

Enfin, la méthode selon l'invention est peu coûteuse. Sa mise en oeuvre n'implique pas nécessairement d'altérer la structure des machines de production existantes.

## Revendications

1. Méthode de surveillance de la composition d'un plasma, ce plasma étant généré à partir de précurseurs déterminés pour le dépôt d'un film sur un matériau polymère, cette méthode comprenant la réception d'intensités lumineuses émises par le plasma, cette méthode étant **caractérisée en ce qu'**elle comprend :
- une étape de choix d'une première gamme de longueurs d'ondes, dite de référence, qui est choisie dans un domaine du spectre d'émission du plasma dans lequel il ne peut exister aucun signal significatif d'une espèce chimique dite parasite, c'est-à-dire qui ne fait pas partie desdits précurseurs déterminés et qui n'est donc normalement pas présente dans le plasma et dont la présence dans le plasma influe sur la nature du film déposé ;
- une étape de choix d'une seconde gamme de longueurs d'ondes qui est choisie dans un domaine du spectre d'émission du plasma dans lequel il est susceptible d'exister un signal significatif d'une espèce chimique parasite ;
- une étape d'acquisition simultanée des intensités lumineuses émises par le plasma dans chacune des deux gammes de longueurs d'ondes choisies ;
- une étape de calcul, à partir desdites intensités lumineuses d'au moins un coefficient de surveillance.

2. Méthode de surveillance de la composition d'un plasma selon la revendication 1, **caractérisée en ce que** les deux gammes de longueurs d'ondes sont de très faible largeur spectrale et correspondent sensiblement à deux longueurs d'ondes λ1 et λ2.

3. Méthode de surveillance de la composition d'un plasma selon la revendication 2, **caractérisée en ce qu'**au moins un coefficient de surveillance est fonction de la différence entre les intensités d'émission pour lesdites première et deuxième longueurs d'ondes λ1 et λ2.

4. Méthode de surveillance de la composition d'un plasma selon la revendication 2 ou 3, **caractérisée en ce qu'**au moins un coefficient de surveillance est fonction de la différence entre les intensités d'émission pour lesdites première et deuxième longueurs d'ondes λ1 et λ2, différence rapportée à la valeur de l'intensité d'émission pour la première ou la deuxième longueur d'onde.

5. Méthode de surveillance de la composition d'un plasma selon la revendication 1, **caractérisée en ce que** les deux gammes de longueurs d'ondes λ1 et λ2 ont chacune une largeur spectrale et correspondent à deux bandes passantes.

6. Méthode de surveillance de la composition d'un plasma selon la revendication 5, **caractérisée en ce qu'**au moins un coefficient de surveillance est fonction de la différence entre les intensités d'émission pour lesdites première et deuxième bandes passantes.

7. Méthode de surveillance de la composition d'un plasma selon la revendication 5 ou 6, **caractérisée en ce qu'**au moins un coefficient de surveillance est fonction de la différence entre les intensités d'émission pour lesdites première et deuxième bandes passantes, différence rapportée à la valeur d'émission pour la première ou la deuxième bande passante.

8. Méthode de surveillance de la composition d'un plasma selon l'une quelconque des revendications 1 à 7, **caractérisée en ce que** ladite espèce chimique parasite choisie susceptible de provoquer un signal significatif dans la seconde gamme de longueurs d'ondes est une espèce non souhaitée dans le film à déposer par plasma sur le matériau polymère.

9. Méthode de surveillance de la composition d'un plasma selon l'une quelconque des revendications précédentes, **caractérisée en ce que** le précurseur gazeux est choisi parmi les alcanes, les alcènes, les alcynes, et les aromatiques, ladite espèce chimique parasite choisie susceptible de provoquer un signal significatif dans la seconde gamme de longueurs d'ondes étant un des constituants de l'air.

10. Méthode de surveillance de la composition d'un plasma selon la revendication 9, **caractérisé en ce que** le précurseur est à base d'acétylène, ladite espèce chimique parasite choisie étant l'azote.

11. Méthode de surveillance de la composition d'un plasma selon la revendication 9, **caractérisé en ce que** le précurseur est à base d'acétylène, ladite espèce chimique parasite choisie étant l'oxygène.

12. Méthode de surveillance de la composition d'un plasma selon l'une quelconque des revendications précédentes, **caractérisée en ce que** les gammes de longueurs d'ondes sont choisies dans la partie du spectre d'émission comprise entre sensiblement 800 et sensiblement 1000 nanomètres.

13. Application de la méthode de surveillance de la composition d'un plasma telle que présentée dans l'une quelconque des revendications précédentes, **caractérisée en ce que** le plasma est un plasma micro-ondes pour dépôt d'un film sur un corps creux en PET.

## Claims

1. A method of monitoring the composition of a plasma, this plasma being generated from defined precursors for the deposition of a film onto a polymer material, this method comprising the measurement of light intensities emitted by the plasma, this method being **characterized in that** it comprises:
a step of selecting a first wavelength range, called reference range, which is selected from a region of the plasma emission spectrum in which no significant signal characteristic of what is called a parasitic chemical species, that is to say one that does not form part of said defined precursors and is therefore normally not present in the plasma, and the presence of which in the plasma influences the nature of the deposited film, can exist;
- a step of selecting a second wavelength range which is selected from a region of the plasma emission spectrum in which a significant signal characteristic of a parasitic chemical species is likely to exist;
- a step of simultaneously acquiring the light intensities emitted by the plasma in each of the two selected wavelength ranges; and
- a step of calculating, from said light intensities, at least one monitoring coefficient.

2. The method of monitoring the composition of a plasma as claimed in claim 1, **characterized in that** the two wavelength ranges have very small spectral widths and correspond substantially to two wavelengths λ₁ and λ₂.

3. The method of monitoring the composition of a plasma as claimed in claim 2, **characterized in that** at least one monitoring coefficient is a function of the difference between the emission intensities for said first and second wavelengths λ₁ and λ₂.

4. The method of monitoring the composition of a plasma as claimed in claim 2 or 3, **characterized in that** at least one monitoring coefficient is a function of the difference between the emission intensities for said first and second wavelengths λ₁ and λ₂, said difference being normalized with the value of the emission intensity for the first or second wavelength.

5. The method of monitoring the composition of a plasma as claimed in claim 1, **characterized in that** the two wavelength ranges λ₁ and λ₂ each have a spectral width and correspond to two bandwidths.

6. The method of monitoring the composition of a plasma as claimed in claim 5, **characterized in that** at least one monitoring coefficient is a function of the difference between the emission intensities for said first and second bandwidths.

7. The method of monitoring the composition of a plasma as claimed in claim 5 or 6, **characterized in that** at least one monitoring coefficient is a function of the difference between the emission intensities for said first and second bandwidths, said difference being normalized to the emission intensity for the first or second bandwidth.

8. The method of monitoring the composition of a plasma as claimed in any one of claims 1 to 7, **characterized in that** said selected parasitic chemical species likely to generate a significant signal in the second wavelength range is a species that is not desired in the film to be plasma deposited on the polymer material.

9. The method of monitoring the composition of a plasma as claimed in any one of the preceding claims, **characterized in that** the gaseous precursor is selected from alkanes, alkenes, alkynes and aromatics, said selected parasitic chemical species likely to generate a significant signal in the second wavelength range being one of the constituents of air.

10. The method of monitoring the composition of a plasma according to claim 9, **characterized in that** the precursor is based on acetylene, said selected parasitic chemical species being nitrogen.

11. The method of monitoring the composition of a plasma according to claim 9, **characterized in that** the precursor is based on acetylene, said selected parasitic chemical species being oxygen.

12. The method of monitoring the composition of a plasma as claimed in any one of the preceding claims, **characterized in that** the wavelength ranges are selected from that part of the emission spectrum lying between approximately 800 nanometers and approximately 1000 nanometers.

13. The application of the method of monitoring the composition of a plasma such as that presented in any one of the preceding claims, **characterized in that** the plasma is a microwave plasma for depositing a film onto a hollow body made of PET.

## Patentansprüche

1. Verfahren zur Überwachung der Zusammensetzung eines Plasmas, wobei dieses Plasma aus bestimmten Vorläufern für die Ablagerung eines Films auf einem Polymermaterial generiert wird, wobei dieses Verfahren die Aufnahme von Lichtintensitäten, die von dem Plasma ausgesendet werden, umfasst, wobei dieses Verfahren **dadurch gekennzeichnet ist, dass** es umfasst:
- einen Schritt der Auswahl eines ersten Wellenlängenbereichs, Referenz genannt, der aus einem Bereich des Emissionsspektrum des Plasmas ausgewählt ist, in dem kein signifikantes Signal einer als parasitär bezeichneten chemischen Substanz existieren kann, das heißt, die kein Bestandteil der bestimmten Vorläufer ist und die demzufolge normalerweise nicht in dem Plasma vorhanden ist und deren Vorhandensein in dem Plasma die Art des abgelagerten Films beeinflusst,
- einen Schritt der Auswahl eines zweiten Wellenlangenbereichs, der aus einem Bereich des Emissionsspektrums des Plasmas ausgewählt ist, in dem ein signifikantes Signal einer parasitären chemischen Substanz existieren kannte,
- einen Schritt der gleichzeitigen Erfassung der von dem Plasma in jeder der zwei ausgewählten Wellenlängenbereichen ausgesendeten Lichtintensitäten,
- einen Schritt der Berechnung mindestens eines Überwachungskoeffizienten anhand der Liehtintensitäten.

2. Verfahren zur Überwachung der Zusammensetzung eines Plasmas nach Anspruch 1, **dadurch gekennzeichnet, dass** die zwei Wellenlängenbereiche eine sehr geringe Spektralbreite haben und etwa zwei Wellenlängen λ1 und λ2 entsprechen.

3. Verfahren zur Überwachung der Zusammensetzung eines Plasmas nach Anspruch 2, **dadurch gekennzeichnet, dass** mindestens ein Überwachungskoeffizient Funktion der Differenz zwischen den Emissionsintensitäten für die erste und zweite Wellenlänge λ1 und λ2 ist.

4. Verfahren zur Überwachung der Zusammensetzung eines Plasmas nach Anspruch 2 ober 3, **dadurch gekennzeichnet, dass** mindestens ein Überwachungskoeffizient Funktion der Differenz zwischen den Emissionsintensitäten für die erste und zweite Wellenlänge λ1 und λ2 ist, wobei sich die Differenz auf den Wert der Emissionsintensität für die erste oder zweite Wellenlänge bezieht.

5. Verfahren zur Überwachung der Zusammensetzung eines Plasmas nach Anspruch 1, **dadurch** gekennzeichet, dass die zwei Wellenlängenbereiche λ1 und λ2 jeweils eine Spektralbreite haben und zwei Bandbreiten entsprechen.

6. Verfahren zur Überwachung der Zusammensetzung eines Plasmas nach Anspruch 5, **dadurch gekennzeichnet, dass** mindestens ein Überwachungskoeffizient Funktion der Differenz zwischen den Emissionsintensitäten für die erste und zweite Bandbreite ist.

7. Verfahren zur Überwachung der Zusammensetzung eines Plasmas nach Anspruch 5 oder 6, **dadurch gekennzeichnet, dass** mindestens ein Überwachungskoeffizient Funktion der Differenz zwischen den Emissionsintensitäten für die erste und zweite Bandbreite ist, wobei sich die Differenz auf den Emissionswert für die erste oder zweite Bandbreite bezieht.

8. Verfahren zur Überwachung der Zusammensetzung eines Plasmas nach einem der Ansprüche 1 bis 7, **dadurch gekennzeichnet, dass** die ausgewählte parasitäre chemische Substanz, die ein signifikantes Signal im zweiten Wellenlängenbereich hervorrufen könnte, eine in dem durch das Plasma auf dem Polymermaterial abzulagernden Film unerwünschte Substanz ist.

9. Verfahren zur Überwachung der Zusammensetzung eines Plasmas nach einem der vorergehenden Ansprüche, **dadurch gekennzeichnet, dass** der gasförmige Vorläufer aus den Alkanen, den Alkenen, den Alkynen und den Aromaten ausgewählt ist, wobei die ausgewählte parasitäre chemische Substanz, die ein signifikantes Signal im zweiten Wellenlängenbereich hervorrufen könnte, einer der Bestandteil der Luft ist.

10. Verfahren zur Überwachung der Zusammensetzung eines Plasmas nach Anspruch 9, **dadurch gekennzeichnet, dass** der Vorläufer auf Acetylenbasis ist, wobei die ausgewählte parasitäre chemische Substanz Stickstoff ist.

11. Verfahren zur Überwachung der Zusammensetzung eines Plasma nach Anspruch 9, **dadurch gekennzeichnet, dass** der Vorläufer auf Acetylenbasis ist, wobei die ausgewählte parasitäre chemische Substanz Sauerstoff ist.

12. Verfahren zur Überwachung der Zusammensetzung eines Plasmas nach einem der vorhergehenden Ansprüche, **dadurch gekennzeichnet, dass** die Wellenlängenbereiche in dem Abschnitt des Emissionsspektrums zwischen etwa 800 und etwa 1000 Nanometer inklusive ausgewählt sind.

13. Anwendung des Verfahrens zur Überwachung der Zusammensetzung eines Plasmas wie in einem der vorhergehenden Ansprüche vorgestellt, **dadurch** gekennzeichet, dass das Plasma ein Mikrowellenplasma zur Ablagerung eines Films auf einen PET-Hohlkörper ist.
